# EUROPEAN PATENT APPLICATION

(11) **EP 4 818 708 A1**
(43) Date of publication of application: **07.10.2026**
(21) Application number: 25168213.4
(22) Date of filing: 03.04.2025
(51) Int. Cl.: G01R 15/18, H05K 1/02

(54) **A MEASUREMENT DEVICE WITH A ROGOWSKI COIL IN A FLEXIBLE CIRCUIT BOARD**

(71) Applicant: Siemens Aktiengesellschaft, 80333 München (DE)
(72) Inventor: Yin, Zuoyuan, 10179 Berlin (DE); Kruß, Martin, 13591 Berlin (DE)
(74) Representative: Siemens Patent Attorneys

(57) **Abstract**

There is described a measurement device (100), in particular at least partially configured as a circuit board, the measurement device (100) comprising:
i) at least one electrically insulating layer (110); and
ii) an electrically conductive structure (120), at least partially formed in the at least one electrically insulating layer (110);

a) wherein the electrically conductive structure (110) is configured as a Rogowski coil; and
b) wherein the measurement device (100) is at least partially flexible.

## Description

### Field of the Invention

The invention refers to a measurement device, comprising at least one electrically insulating layer and an electrically conductive structure, at least partially formed in the electrically insulating layer, wherein the electrically conductive structure is configured as a Rogowski coil, and wherein the measurement device is at least partially flexible, in particular configured as a flexible circuit board. The invention further relates to a method of handling said measurement device, and to a use of a Rogowski coil in a flexible circuit board.

The invention can hence relate to the technical field of measurement devices, e.g. for electric measurements, such as a Rogowski coil sensor.

### Technical Background

Measurement devices such as sensors are used to measure physical properties of an object under measurement, for example the electric current in a conductor. For example, a Rogowski coil is an established current sensor used e.g. for measuring alternating current (AC) and transient currents. Unlike traditional current transformers (CTs), it has no magnetic core, making it lightweight, linear, and immune to saturation. Nevertheless, conventional Rogowski coils and their associated wiring can be bulky and rigid, posing challenges in installations where space is limited or where flexibility is required.

Conventional wire-wound Rogowski coils are widely used for non-intrusive current sensing. These coils consist of a helical winding of wire around a cylindrical or toroidal core. While effective, traditional Rogowski coils may be bulky, rigid, and less flexible compared to printed circuit board (PCB)-based designs. PCB-based Rogowski coils are a type of current sensor that utilizes a PCB as the substrate for the coil winding. These coils are commonly used for non-intrusive current sensing in various applications, such as power electronics, energy monitoring systems, and electrical equipment. These PCBs can be manufactured in a precise and low-cost manner. However, they are rigid and thus difficult to handle.

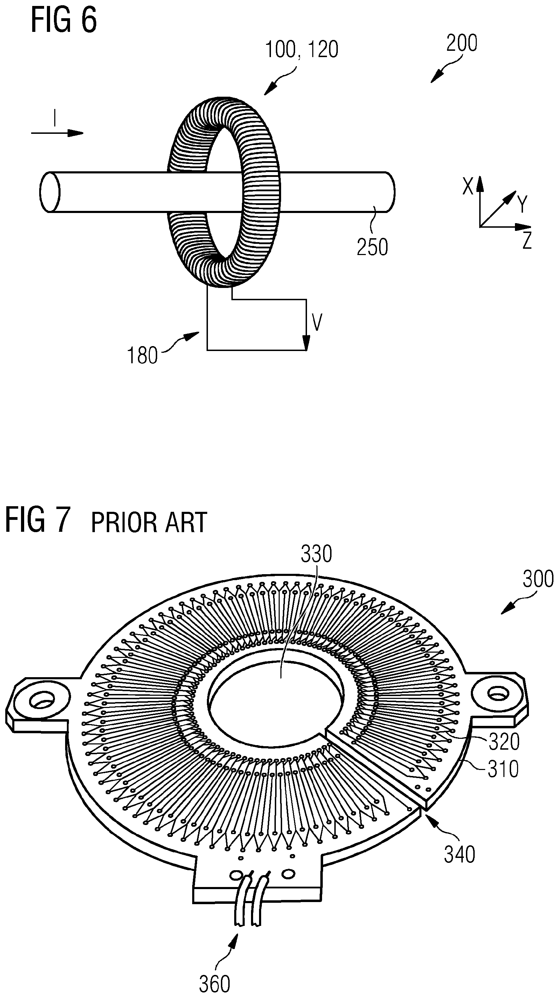

Figure 7 shows an example of a conventional PCB 300 with a Rogowski coil 320 embedded in the reinforced resin material 310 (e.g. FR4) of the PCB. An opening 330 is formed in the PCB and the Rogowski coil 320 is wound around said opening 330. The electric current in a conductor (object to be measured) can be measured using the Rogowski coil 320 (and a further processing device, connectable by electric contact 360), when the conductor is arranged in said opening 330 (and surrounded by the Rogowski coil 320). For placing the conductor (e.g. a cable) in the opening 330, a slit 340 is provided. The slit 340 is very thin, so that operation of the Rogowski coil 320 is not disturbed. However, due to the high stiffness of the reinforced resin 310 of the printed circuit board 300, it is cumbersome to introduce the cable through the slit 340 into the opening 330 for performing the measurement. Further, only very thin cables could be used for the measurement. Because the cable cannot be fixed in the center, the induced magnetic field is uneven, which affects the measurement accuracy.

### Summary of the invention

There may be a need to provide an efficient and reliable measurement device.

A measurement device, a measurement device arrangement, a method, and a use are described in the following.

According to a first aspect of the invention, there is described a measurement device (e.g. a sensor device), in particular at least partially configured as a circuit board (e.g. a flexible printed circuit board), the measurement device comprising:
i) at least one (electrically insulating) layer, and
ii) an electrically conductive structure (e.g. comprising a metal such as copper), at least partially formed/embedded in the electrically insulating layer (e.g. wound through the material of the electrically insulating layer).

The electrically conductive structure is configured as a Rogowski coil (e.g. provided as a coil wound in/on circuit board material for performing measurements).

The measurement device (in particular the at least one electrically insulating layer) is at least partially flexible (e.g. comprising a flexible material such as polyimide).

According to a second aspect of the invention, there is described a measurement device arrangement, comprising:
i) a measurement device as described above, and
ii) an object under measurement arranged in a measurement position with respect to the Rogowski coil (e.g. extending through an opening in the electrically insulating layer, wherein the Rogowski coil is wound around said opening). In an embodiment, the object under measurement comprises a conductor, for example at least one of a cable, a wire, a trace, a busbar.

According to a third aspect of the invention, there is described a method of handling a measurement device, the method comprising:
i) providing a measurement device as described above;
ii) providing an object under measurement; and
iii) arranging the object under measurement at least partially in the measurement device in a measurement position with respect to the Rogowski coil (in particular by bending the flexible measurement device to insert the object under measurement).

According to a fourth aspect of the invention, there is described a use (method of using) of a Rogowski coil in a flexible circuit board (e.g. a FPC), in particular to perform a measurement with respect to an object under measurement.

In the context of the present document, the term "measurement device" may in particular refer to a device suitable to measure a specific property with respect to an object under measurement. The specific property to be measured may be a physical property such an electric property or a temperature. For example, the measurement device may be configured to measure an (alternating) electric current of a cable (object under measurement). In a preferred embodiment, the measurement device comprises a Rogowski coil for performing such a measurement. The electric current measured by such a Rogowski coil may be further evaluated/processed by an evaluation device that may be part of the measurement device or may operate separately/remote of the measurement device. In an embodiment, the measurement device may be arranged in a specific position, e.g. for long-time monitoring. In another embodiment, the measurement device may be used as a portable sensor device for different applications.

In the context of the present document, the term "electrically insulating layer" may in particular refer to a layer that comprises electrically insulating properties. In an embodiment, the electrically insulating layer may be configured as a (printed) circuit board or as a part thereof. In an embodiment, the electrically insulating layer may comprise circuit board materials such as reinforced or non-reinforced resin. In a preferred embodiment, the electrically insulating layer may comprise a flexible (PCB) material, e.g. polyimide. In an embodiment, the electrically insulating layer is at least partially bendable/foldable. In an embodiment, the electrically insulating layer is a continuous layer or a discontinuous layer. The electrically insulating layer may be plate-shaped and/or comprise two opposed main surfaces. These main surfaces may define the planar/horizontal (x, y) extension (directions of main extension). The thickness direction (z) of the electrically insulating layer may be perpendicular to said main surfaces and may not be a direction of main extension (extension along z much shorter than along x and y). In an embodiment, the at least one electrically insulating layer comprises two or more (stacked) layers.

In the context of the present document, the term "circuit board" may in particular refer to a device that comprises at least one electrically insulating layer (see above) and/or at least one electrically conductive structure/layer. A circuit board generally serves as a carrier for electric components such as processors. However, a circuit board may also be used to realize a measurement device, e.g. by embedding a Rogowski coil in circuit board resin material. Conventionally, a Rogowski coil may be embedded in a rigid printed circuit board. Yet, according to the present invention, a flexible circuit board may be used. Such a flexible circuit board may be for example a "flexible printed circuit" (FPC), a "flexible circuit board" (FCB) or a "full-flex or rigid-flex PCB". These are some examples of specific types of circuit boards that are configured to have flexible properties (e.g. due to the applied materials).

In the context of the present document, the term "electrically conductive structure" may in particular refer to a structure that comprises electrically conductive properties. For example, such an electrically conductive structure may comprise a metal such as copper. In a preferred embodiment, the electrically conductive structure has (at least partially) the shape of a coil, in particular a Rogowski coil. In an embodiment, the electrically conductive structure comprises a first portion on a first main surface of the electrically insulating layer (circuit board) and a second portion on a second (opposed) main surface of said electrically insulating layer. Hereby, the first/second portion may be implemented as a trace/pad. Further, a third portion of the electrically conductive structure may extend through the electrically insulating layer, thereby connecting the first portion at the first main surface and the second portion at the second main surface (as a through connection, e.g. a via). In this manner, a coil may be provided that is wound through the circuit board material. In such an embodiment, the electrically conductive structure is arranged at least partially in (and at least partially on) the electrically insulating layer.

In the context of the present document, the term "Rogowski coil" may in particular refer to a coil-shaped electrically conductive structure that is wound (around a core or through a PCB layer) and arranged in a circle-like manner. In an embodiment, a Rogowski coil may be wound around an opening in a circuit board layer. An object under measurement (e.g. a cable) may be placed in a measurement portion perpendicular to the directions of main extension of the circuit board (and parallel to the thickness direction). Descriptively speaking, the cable is passing through said opening. In this manner, the Rogowski coil may surround the object under measurement. A Rogowski coil may be used as a type of current sensor to measure alternating current (AC) and/or pulsed currents. The coil may e.g. measure the rate of change of current (dl/dt) through the conductor, and its output can be a voltage signal proportional to that rate.

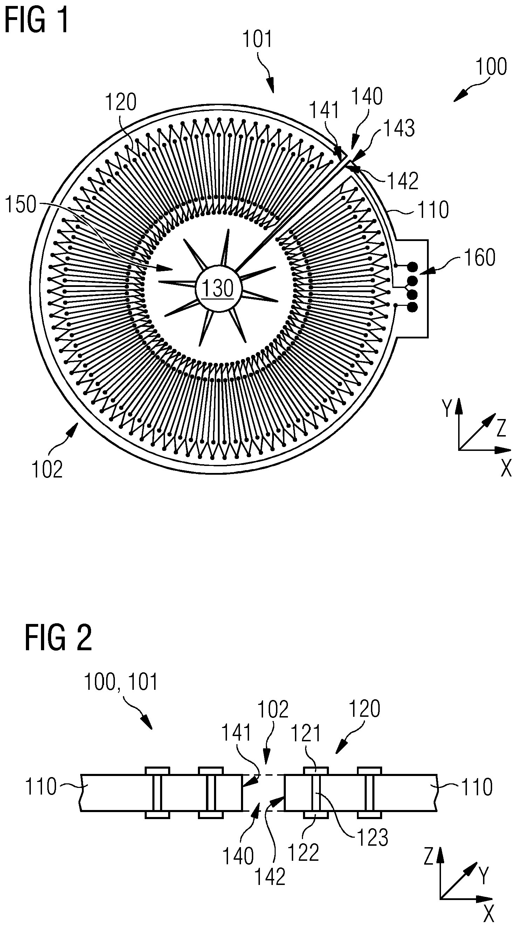

In an exemplary example, a Rogowski coil may be an (air core) toroid with N turns around it. Consider a trace with a finite length spatial located on a circular circuit board (compare Figure 1). Due to time varying current flowing through the conductor, a magnetic field is created around it. Consider an infinitesimal conductive element "dr" at a distance of x from the origin. As per the Biot Savart Law, the magnetic field strength dH at distance x is given by the following equation: dH = (I) / (2*π*x).

In the context of the present document, the term "flexible" may in particular refer to the property of (at least a part of) a measurement device to be flexible (bendable, twistable. foldable). In other words, the measurement device may be bent (to a certain extent) without breaking. After bending, the measurement device may (at least partially) return to its original state. In an embodiment, the electrically insulating layer may be flexible, e.g. comprise a flexible material. In an embodiment, the measurement device is at least partially designed as a flexible printed circuit. In a further embodiment, the measurement device (in particular the electrically insulating layer) comprises a flexible/bendable portion. For example, such a bendable portion may be arranged between two rigid portions and enable a bending of the rigid portions towards each other or away from each other. In a specific example, such a flexible portion may be realized by a thin layer and/or a different material. In a further embodiment, the electrically conductive structure may be (at least partially) flexible, for example especially thin metal/copper structures may be used.

According to an exemplary embodiment, the invention may be based on the idea that an efficient and reliable measurement device may be provided, when a Rogowski coil is implemented as an electrically conductive structure at least partially in an electric insulating layer (of a circuit board), wherein the measurement device (in particular said electrically insulating layer) is at least partially flexible. For example, the Rogowski coil can be implemented in a flexible printed circuit (FPC), e.g. by providing the electrically insulating layer with a flexible material such as polyimide. Such an approach may provide a plurality of advantages over conventional designs, e.g. regarding flexibility, modularity, scalability, customizability, cost-effectiveness, measurement conditions, and precision.

Flexibility: the invention may aim to address this issue by providing a flexible circuit board that can be bent or folded to fit into tight spaces or conform to specific shapes. The flexible nature of the measurement device (e.g. FPC) may allow the Rogowski coil to conform to various shapes and sizes, enabling it to adapt to tight spaces or irregularly shaped conductors. This feature may ensure that the coils can be easily installed in diverse environments without compromising performance. The flexible cluster structure in the middle, which provides support, may allow it to be used with cables of varying thicknesses to a certain extent.

High precision: conventional Rogowski coils, which are hand-wound or machine-wound, cannot guarantee that each wire is tightly and evenly wound. This leads to the accuracy and consistency of the coil being affected. Circuit board Rogowski coils are manufactured using precise printed circuit board technology, where the layout and winding of the wires are very accurate. Each coil manufacturing process is standardized to ensure that the performance of each coil is consistent. For general PCB Rogowski coils, a main reason affecting their measurement accuracy is the inability to ensure the coil is centered. In contrast, a center cluster design of the inventive (FPC) Rogowski coil may allow an object under measurement like a cable to be fixed in the middle of the coil (because the flexible material is the same and the thickness is consistent, the elasticity of each cluster is similar), ensuring the consistency of distance x guarantees the consistency of the magnetic field strength.

Modularity and Scalability: a cascadable (stacked) design of the measurement device (Rogowski coils) may allow multiple units (of circuit boards) to be connected together in series through a connector and double sided sticker configurations. This modularity may enable scalability, allowing users to adjust the number of coils to meet specific measurement requirements or cover a wider range of currents. Additionally, the modular design facilitates easy replacement or expansion of the sensing system as needed. The invention could target the challenge of scalability and expandability by providing a solution that allows multiple Rogowski coils to be easily connected or cascaded together to increase the measurement range or accuracy.

Customizability: flexible circuit boards may be easily customized in terms of size, shape, and layout to suit the requirements of different applications. This customizability may allow engineers to optimize the design of the Rogowski coils for specific installation scenarios, ensuring optimal performance and integration with the existing infrastructure. Off-the-shelf current sensing solutions may not always meet the specific requirements of a particular application. The flexibility of using flexible circuit boards may allow for easy customization of the sensor dimensions, shape, and other parameters to better integrate with the existing infrastructure or accommodate unique installation constraints.

Cost-effectiveness: by leveraging flexible circuit board technology, the invention may offer a cost-effective alternative to conventional current sensing solutions. Flexible circuit boards may be relatively inexpensive to manufacture compared to other sensing technologies, potentially helping to reduce overall system costs while maintaining high performance and reliability. Another possible technical challenge could be related to cost-effectiveness and manufacturing efficiency. The invention might seek to reduce costs or streamline the manufacturing process of Rogowski coil systems by leveraging flexible circuit board technology and innovative manufacturing techniques.

Non-invasive measurement: like traditional Rogowski coils, the (cascadable) coils made of flexible circuit boards may offer non-invasive current sensing, eliminating the need for direct electrical contact with the conductor being measured. This feature may ensure minimal disruption to the existing electrical infrastructure and reduce the risk of electrical hazards during installation and operation. Many applications require non-invasive current measurement to avoid interrupting or modifying the existing electrical infrastructure. Rogowski coils are known for their non-invasive nature, and the invention may build upon this advantage to provide a versatile solution for a wide range of non-intrusive current sensing applications.

Electromagnetic interference (EMI) and noise can degrade the accuracy of current measurements. The invention may minimize interference and noise by incorporating shielding or noise reduction techniques into the design of the Rogowski coil assembly.

Overall, the technical features of the invention may enable flexible, scalable, and cost-effective current sensing solutions that can be easily customized and integrated into various applications. By addressing the key technical challenges associated with current sensing, the invention may provide a versatile solution that meets the diverse needs of users across different industries and sectors.

### Exemplary Embodiments

In an embodiment, the measurement device is (at least partially) configured as at least one of a flexible printed circuit (FPC), a flexible circuit board (FCB), a full-flex or a rigid-flex printed circuit board (PCB). This may provide the advantage that established and reliable manufacture techniques and materials can be directly applied. There exist different terminologies with respect to (printed) circuit boards with flexible properties. In the present context, the measurement device may be implemented as a circuit/wiring board that is (at least partially) flexible. Existing technologies such as FPC, FCB or rigid-flex PCB may hence be directly applied.

In an embodiment, the measurement device comprises a flexible material. By providing (at least a part of) the measurement device (e.g. the electrically insulating layer and/or the electrically conductive structure) with a flexible material, the flexible property may be enabled in an easy and straightforward manner.

In an embodiment, the at least one electrically insulating layer comprises at least one of polyimide (PI), polyethylene terephthalate (PET), liquid crystal polymer (LCP), thermoplastic polyurethane (TPU). These are examples of established flexible material for circuit boards that may be directly implemented.

In an embodiment, the electrically conductive structure comprises a flexible metal (material), for example thin/rolled copper. In an embodiment, the measurement device (in particular the electrically insulating layer) comprises a flexible portion and a rigid portion. In an embodiment, the measurement device (in particular the electrically insulating layer) comprises a flexible portion between two rigid portions, so that the rigid portion may be movable towards each other/away from each other via the flexible portion.

In an embodiment, the measurement device further comprises an opening (aperture, hole) through the at least one electrically insulating layer. In an embodiment, the opening is oriented along (extends along) the thickness direction (z) of the at least one electrically insulating layer. In an embodiment, the electrically conductive structure is formed, in particular wound, at least partially around said opening (e.g. surrounding the opening). In this manner, a measurement position for an object under measurement may be provided in an easy and design-flexible manner.

In an embodiment, the opening is configured to accommodate an (elongated) object under measurement (in particular a conductor) in a measurement position. In an embodiment, the opening is configured so that the object under measurement is oriented (essentially) parallel to the thickness direction (z) of the at least one electrically insulating layer. In an embodiment, the opening is configured so that the object under measurement is oriented (essentially) perpendicular to the directions of main extension (x, y) of the at least one electrically insulating layer.

In an embodiment, the measurement device further comprises an insertion structure (e.g. a slit or a slot). In an embodiment, the insertion structure is arranged between the opening and an external surface of the at least one electrically insulating layer. In an embodiment, the insertion structure is configured to insert (enable insertion of) the object under measurement in the opening (into the measurement position). In other words, the object under measurement may be guided through the insertion structure to enter the opening. In many cases, a conductor (in particular when in operation) is too long or it is impracticable to simply lead the conductor through the opening.

In an embodiment, at least a portion of the insertion structure is bendable. In an embodiment, the method comprises: at least partially bending the measurement device, in particular with respect to the insertion structure. This may provide the advantage that the flexible property of the measurement device may be used to insert (essentially any size of) the object under measurement in the measurement position in an efficient and easy manner.

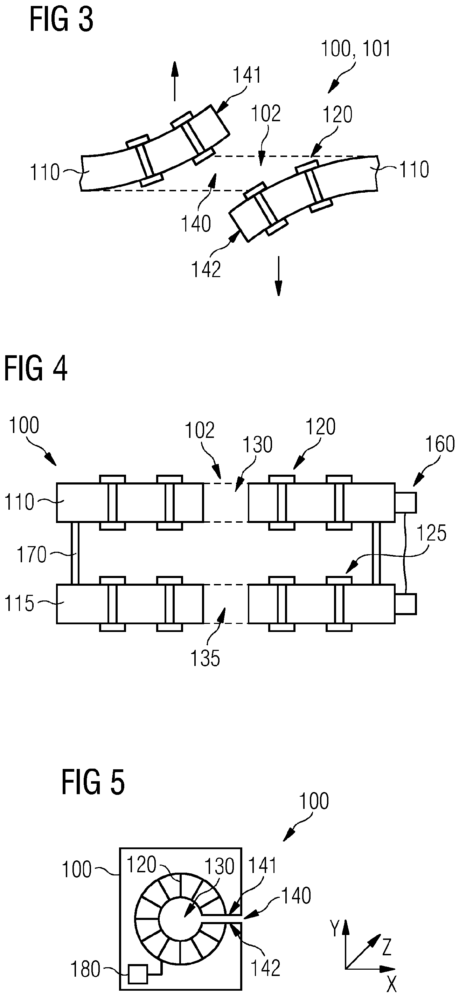

In an embodiment, the insertion structure is defined by two opposed sidewalls/edges of the at least one electrically insulating layer. For example, the sidewalls may define a slit in between. In an embodiment, the two opposed sidewalls are bendable/movable/foldable with respect to each other. In an embodiment, this property is based on the flexibility of the measurement device (compare e.g. Figure 3). This may provide the advantage that the insertion structure may be adapted to different applications in a highly flexible manner. Depending on the size/dimensions of the object under measurement, the size/dimension of the insertion structure may be adjusted by bending the sidewalls which define the insertion structure. Thereby, even very large conductors like busbars may be inserted into the measurement position in an efficient and reliable manner.

In an embodiment, the electrically conductive structure comprises at least one of:
i) a first portion at/on a first (external) main surface of the at least one electrically insulating layer,
ii) a second portion at/on a second (external) main surface (in particular opposed to the first main surface) of the at least one electrically insulating layer,
iii) a third portion that extends through the at least one electrically insulating layer (e.g. along the thickness direction). In particular, the third portion connects the first portion and the second portion.

This may provide the advantage that a Rogowski coil may be implemented in a circuit board in a precise and reliable manner, using established circuit board techniques, e.g. traces/pads and vias.

In an embodiment, the measurement device further comprises (a further circuit board comprising) a further at least one electrically insulating layer, and a further electrically conductive structure, at least partially formed in the further at least one electrically insulating layer. In an embodiment, the further electrically conductive structure is configured as a further Rogowski coil. In an embodiment, the further electrically insulating layer and/or the further electrically conductive structure are at least partially flexible. In an embodiment, the at least one electrically insulating layer and the further at least one electrically insulating layer are stacked, for example oriented in parallel with each other. In an embodiment, two stacked circuit boards are connected by a connection structure (e.g. a spacer). This may provide the advantage that a cascaded design is enabled, wherein two or more circuit boards (with similar or different properties) are stacked, enabling a large variety of applications.

In an embodiment, the further at least one electrically insulating layer comprises a further opening. In an embodiment, the opening and the further opening are (at least partially) aligned, so that they can accommodate the object under measurement in a common measurement position (e.g. the object extending through the opening and the further opening). In an embodiment, the opening and the further opening have a similar or different diameter. In an embodiment, the electrically conductive structure and the further electrically conductive structure have a similar or different number of windings. Thereby, the object under measurement may be investigated under different conditions which may be directly comparable.

In an embodiment, the electrically conductive structure and the further electrically conductive structure are electrically connected, in particular by at least one electric connector. For example, the Rogowski coils of two or more circuit board may be coupled, e.g. connected in series (or in parallel). Thereby, measurement results of different coils may be combined in an efficient and flexible manner. The electric connector may e.g. comprise at least one of a wire, a cable, a pillar, a via, a solder material, etc.

In an embodiment, the at least one electrically insulating layer and the further at least one electrically insulating layer are spatially separated, in particular by a fluid/air gap. A small gap may be provided, to prevent interference between the two or more Rogowski coils. The gap (space) may be established by a connection structure which may serve at the same time as a spacer and as a connection/stabilization structure.

In an embodiment, a further insertion structure may be provided in the further at least one electrically insulating layer. In an embodiment, the insertion structure and the further insertion structure are at least partially aligned. In an embodiment, the (sidewalls of the) insertion structure and the further insertion structure are bendable at the same time. In this manner, an object under measurement may be inserted into the opening and the further opening at the same time. In an example, the whole circuit board stack may be bended/folded at once.

In an embodiment, the measurement device further comprises an evaluation device, in particular comprising at least one processor, to evaluate/process a measurement (measurement data) performed/obtained with respect to the Rogowski coil. In an embodiment, the measurement device is configured as a (independent) stand-alone device/module. This may provide the advantage that the measurement device can be applied independent of further devices, since the equipment for measuring and evaluating/processing the measured data is already present in the measurement device (on the circuit board). Such a stand-alone device may be applied in a flexible manner for a large variety of measurements.

In an embodiment, the measurement device further comprises a holding structure (in particular around the opening) to hold the object under measurement in place (in particular in the measurement position). In an embodiment, the holding structure is configured to center the object under measurement in the opening (in the Rogowski coil). This may provide the advantage that the precision of the measurement is highly increased. Said holding structure may be arranged between the opening and the Rogowski coil. In an example, the holding structure is planar. In an example, the holding structure comprises elongated apertures (slits), thereby making the holding structure (at least partially) flexible. Additionally or alternatively, the holding structure comprises a flexible material. The holding structure can be used to hold the object under measurement (in particular a cable) stable in place (fixing it reversibly) during the measurement. In other words, the holding structure can fix the object under measurement in the (centered) measurement position. For general PCB Rogowski coils, a main reason affecting their measurement accuracy is the inability to ensure the cable is centered. In contrast, a center design based on the holding structure may allow an object under measurement like a cable to be fixed in the middle of the coil (this approach may also be suitable for a stacked/cascaded design).

In an embodiment, the invention may enable a higher number of windings requiring less space than conventional architecture. In an embodiment, the invention enables a high degree of individualization.

It should be noted that embodiments of the invention have been described with reference to various subject-matters. In particular, some embodiments have been described with reference to method claims, while other embodiments have been described with reference to apparatus claims. However, a skilled person will infer from the foregoing and the following description that, unless otherwise indicated, in addition to any combination of features belonging to one type of subject-matter, any combination of features relating to different subject-matter is also considered to be disclosed by this document. This is particularly the case between features of the method claims and features of the apparatus claims.

The aspects defined above and further aspects of the present invention result from the examples of embodiments to be described below and are explained by reference to the examples of embodiments. The invention is described in more detail below with reference to embodiments to which the invention is not limited.

### Brief Description of the Drawings

Figure 1 shows a top view on a measurement device, according to an exemplary embodiment of the invention.
Figure 2 shows a cross-section through a measurement device at an insertion structure, according to an exemplary embodiment of the invention.
Figure 3 shows the cross-section through the measurement device at the insertion structure, wherein the flexible measurement device is bent, according to an exemplary embodiment of the invention.
Figure 4 shows a cross-section through a measurement device that comprises a plurality of stacked electrically insulating layers, according to an exemplary embodiment of the invention.
Figure 5 shows a top view on a measurement device with an evaluation device, according to an exemplary embodiment of the invention.
Figure 6 shows a side view of a measurement device arrangement, according to an exemplary embodiment of the invention.
Figure 7 shows conventional printed circuit board with a Rogowski coil.

### Detailed Description of the Drawings

The representations in the drawings are schematic. It should be noted that in different illustrations, similar or identical elements or features are provided with the same reference signs or with reference signs that differ from the corresponding reference signs only within the first digit. In order to avoid unnecessary repetition, elements or features that have already been explained in relation to a previously described embodiment are not explained again at a later point in the description.

In addition, spatially relative terms such as "front" and "back", "up" and "down", "left" and "right", etc. are used to describe the relationship of one element to another element, as shown in the figures. For example, the spatially relative terms can apply to orientations used that deviate from the orientation shown in the figures. Obviously, these spatially relative terms refer only to a simplification of the description and the orientation shown in the figures and are not necessarily limiting, since an apparatus according to an embodiment of the invention may assume orientations other than those shown in the figures, in particular when it is used.

Figure 1 shows a top view on a measurement device 100, according to an exemplary embodiment of the invention. The measurement device 100 is configured as a (printed) circuit board, in particular a flexible printed circuit (FPC) and comprises at least one electrically insulating layer 110 (can be one or more layers). Said electrically insulating layer 110 comprises a flexible material, for example polyimide. An electrically conductive structure 120 is partially formed in the electrically insulating layer 110. As shown in detail in Figure 2, a first/second portion of the electrically conductive structure 120 is formed on the upper/lower main surface (both extending in the planar direction along x and y) of the electrically insulating layer 110 in form of pads/traces. A third portion of the electrically conductive structure 120 connects the first/second portion by extending through the electrically insulating layer 110 in the thickness direction z like a via connection. Thereby, the electrically conductive structure 120 is partially embedded in the electrically insulating layer 110 and is wound around the electrically insulating layer 110, thereby being configured as a Rogowski coil.

An opening (through hole) 130 is formed through the at least one electrically insulating layer 110 and is oriented along the thickness direction z of the at least one electrically insulating layer 110. Hereby, the electrically conductive structure 120 is formed/ wound around said opening 130. Accordingly, the opening 130 is configured to accommodate an elongated object under measurement 250, like a conductor, in a measurement position (compare Figure 6), so that the elongated object under measurement 250 is oriented essentially parallel to the thickness direction z of the at least one electrically insulating layer 110.

The measurement device 100 further comprises an insertion structure 140 formed as a slit between the opening 130 and an external edge/surface 143 of the at least one electrically insulating layer 110. The insertion structure 140 is configured to enable the insertion of the object under measurement 250 in the opening 130 into the measurement position (compare Figure 6).

Electric connections 160 enable an electric connection to a further evaluation device and/or a further Rogowski coil (compare Figure 4). In this example, a foreground 101 and a background 102 portion of the measurement device 100 are defined. The following Figures 2 to 4 refer to this definition.

In comparison to conventional Rogowski coil PCBs (compare Figure 7), the described measurement device 100 is at least partially flexible. For example, the electrically insulating layer 110 comprises a flexible material and is therefore bendable. In this manner, the sidewalls of the insertion structure 140 are bendable with respect to each other, enabling an efficient and reliable insertion of a conductor (e.g. a cable) 250 into the opening 130 into the measurement position (compare Figure 3 below).

In the example of Figure 1, the measurement device further comprises a holding structure 150 that surrounds the opening 130. Said holding structure is arranged between the opening 130 and the Rogowski coil 120. In the example shown, the holding structure 150 is planar and has a sun/star-like appearance around the opening 130. In other words, the holding structure 150 comprises elongated apertures (slits), thereby making the holding structure (at least partially) flexible (additionally or alternatively the material of the holding structure can be flexible). The holding structure 150 can be used to hold the object under measurement (in particular a cable) stable in place (fixing it reversibly) during the measurement. In other words, the holding structure 150 can fix the object under measurement 250 in the measurement position. In this embodiment, the insertion structure 140 extends through the holding structure 150 to the opening 130.

For general PCB Rogowski coils, a main reason affecting their measurement accuracy is the inability to ensure the cable is centered. In contrast, a center design based on the holding structure 150 may allow an object under measurement like a cable to be fixed in the middle/center of the coil (this approach may also be suitable for a stacked/cascaded design). This ensures the consistency of distance x (see above) and may guarantee the consistency of the magnetic field strength.

Figure 2 shows a cross-section through a measurement device 100 at the insertion structure 140, according to an exemplary embodiment of the invention. The cross-section through the at least one electrically insulating layer 110 shows the insertion structure 140 for inserting the object under measurement 250 into the opening 130. The Figure refers to the foreground portion 101 (see Figure 1), while the background portion 102 is only shown schematically.

The electrically conductive structure 120 (Rogowski coil) comprises: a first portion 121 at/on a first main surface of the at least one electrically insulating layer 110 and a second portion 122 at/on a second main surface (opposed to the first main surface) of the at least one electrically insulating layer 110. Further, the electrically conductive structure 120 comprises a third portion 123 that extends through the at least one electrically insulating layer 110 along the thickness direction z and connects the first portion 121 and the second portion 122. In this manner, the electrically conductive structure 120 can be wound through the at least one electrically insulating layer 110 in form of the Rogowski coil. It is further shown that the insertion structure 140 is defined by two opposed sidewalls 141, 142 of the at least one electrically insulating layer 110.

Figure 3 shows the cross-section through the measurement device 100 at the insertion structure 140 of Figure 2, wherein the flexible measurement device 100 is bent, according to an exemplary embodiment of the invention. Specifically, the two opposed sidewalls 141, 142 are bent with respect to each other based on the flexibility of the measurement device 100 (for example the flexible material of the at least one electrically insulating layer 110). In this example, the left side 141 of the insertion structure 140 is bent upwards, while the right side 142 of the insertion structure 140 is bent downwards. In this manner, a large space is provided for inserting the object to be measured 250 (e.g. a large conductor like a busbar) in the opening 130 into the measurement position.

Figure 4 shows a cross-section through a measurement device 100 that comprises a plurality of stacked electrically insulating layers 110, 115 (circuits boards), according to an exemplary embodiment of the invention. In addition to the electrically insulating layer 110 described for Figures 1 to 3, the measurement device 100 of Figure 4 comprises a further at least one electrically insulating layer 115 with a further electrically conductive structure 125, at least partially formed in the further at least one electrically insulating layer 115, wherein the further electrically conductive structure 125 is configured as a further Rogowski coil. Like the electrically insulating layer 110, the further electrically insulating layer 115 is also flexible (e.g. made of a flexible material). In Figure 4, the at least one electrically insulating layer 110 and the further at least one electrically insulating layer 115 are stacked, here oriented in parallel with each other. The layers 110, 115 are separated/spaced by a connection structure 170, here in form of pillars. In this manner, further circuit boards can be stacked on top of each other, providing a cascaded measurement device 100.

The further at least one electrically insulating layer 115 comprises a further opening 135 and, in the example of Figure 4, the opening 130 and the further opening 135 are aligned so that they can accommodate the object under measurement 250 in a common measurement position (extending through both openings 130, 135). In this example, the opening 130 and the further opening 135 have a similar diameter (can also be different) and the electrically conductive structure 120 and the further electrically conductive structure 125 have a similar number of windings (can also be different).

The electrically conductive structure 120 and the further electrically conductive structure 125 are electrically connected by at least one electric connector 160 (here schematically shown by a wire, can also be a pillar, a solder ball or another electric connector). The at least one electrically insulating layer 110 and the further at least one electrically insulating layer 115 are spatially separated by an air gap (not in direct physical contact).

Figure 5 shows a top view on a measurement device 100 with an evaluation device 180, according to an exemplary embodiment of the invention. The measurement device 100 of Figure 5 is comparable to the measurement device 100 of Figure 1, yet is more complex. The main surface of the at least one electrically insulating layer 110 is larger and offers space for an evaluation device 180 (e.g. a processor), configured to evaluate/process the measurement done by the Rogowski coil 120.The measurement device 100 can be used as a stand-alone device/module since it is independent of other devices and can do all processing of the measurement data by itself.

Figure 6 shows a side view of a measurement device arrangement 200, according to an exemplary embodiment of the invention. The measurement device arrangement 200 comprises a measurement device 100 as described for Figures 1 to 5. Yet, only the electrically conductive structure 120 (the Rogowski coil) is shown for better overview. Further, the measurement device arrangement 200 comprises the elongated object under measurement 250 (here a cable) arranged in the measurement position with respect to the Rogowski coil 120. The object under measurement 250 is oriented parallel to the thickness direction z of the at least one electrically insulating layer 110 and perpendicular to the main surfaces (directions of main extension x and y). In this measurement position, a physical property (e.g. an alternating current) with respect to the object under measurement 250 can be measured using the Rogowski coil 120.

It should be noted that the term "comprising" does not exclude other elements or steps, and the use of the article "a" does not preclude a multitude. Elements that are described in connection with different embodiments can also be combined. It should also be noted that reference signs in the claims should not be interpreted as limiting the scope of the claims.

Regardless of the grammatical gender of a particular term, it includes people with male, female or other gender identities.

### Reference signs

- 100: Measurement device, flexible circuit board
- 101: Foreground
- 102: Background
- 110: Electrically insulating layer
- 115: Further electrically insulating layer
- 120: Electrically conductive structure, Rogowski coil
- 121: First portion
- 122: Second portion
- 123: Third/through portion
- 125: Further electrically conductive structure, further Rogowski coil
- 130: Opening
- 135: Further opening
- 140: Insertion structure
- 141: First sidewall
- 142: Second sidewall
- 143: External surface
- 150: Holding structure
- 160: Electric connector
- 170: Connection structure
- 180: Evaluation device, processor
- 200: Measurement device arrangement
- 250: Object to be measured, conductor

## Claims

1. A measurement device (100), in particular at least partially configured as a circuit board, the measurement device (100) comprising:
at least one electrically insulating layer (110); and
an electrically conductive structure (120), at least partially formed in the electrically insulating layer (110);
wherein the electrically conductive structure (110) is configured as a Rogowski coil; and
wherein the measurement device (100) is at least partially flexible.

2. The measurement device (100) according to claim 1,
wherein the measurement device (100) is configured as at least one of a flexible printed circuit, FPC,
a flexible circuit board, FCB,
a flexible printed circuit board, PCB,
a rigid-flex printed circuit board.

3. The measurement device (100) according to claim 1 or 2,
wherein the measurement device (100) comprises a flexible material,
in particular
wherein the at least one electrically insulating layer (110) comprises at least one of polyimide, PI, polyethylene terephthalate, PET, liquid crystal polymer, LCP, thermoplastic polyurethane, TPU; and/or
wherein the electrically conductive structure (120) comprises a flexible metal, in particular copper.

4. The measurement device (100) according to one of the preceding claims, further comprising:
an opening (130) through the at least one electrically insulating layer (110), in particular oriented along the thickness direction (z) of the at least one electrically insulating layer (110), and
wherein the electrically conductive structure (120) is formed, in particular wound, at least partially around said opening (130).

5. The measurement device (100) according to claim 4,
wherein the opening (130) is configured to accommodate an object under measurement (250), in particular a conductor, in a measurement position,
in particular so that the object under measurement (250) is oriented essentially parallel to the thickness direction (z) of the at least one electrically insulating layer (110).

6. The measurement device (100) according to claim 4 or 5, further comprising:
an insertion structure (140), in particular a slit, between the opening (130) and an external surface (143) of the at least one electrically insulating layer (110),
wherein the insertion structure (140) is configured to insert the object under measurement (250) in the opening (130) into the measurement position,
in particular wherein at least a portion of the insertion structure (140) is bendable.

7. The measurement device (100) according to claim 6,
wherein the insertion structure (140) is defined by two opposed sidewalls (141, 142) of the at least one electrically insulating layer (110), and
wherein the two opposed sidewalls (141, 142) are bendable with respect to each other, in particular based on the flexibility of the measurement device (100).

8. The measurement device (100) according to one of the preceding claims,
wherein the electrically conductive structure (120) comprises:
a first portion (121) at a first main surface of the at least one electrically insulating layer (110);
a second portion (122) at a second main surface, in particular opposed to the first main surface, of the at least one electrically insulating layer (110); and
a third portion (123) that extends through the at least one electrically insulating layer (110) along the thickness direction (z) and connects the first portion (121) and the second portion (122).

9. The measurement device (100) according to one of the preceding claims, further comprising:
a further at least one electrically insulating layer (115), and
a further electrically conductive structure (125), at least partially formed in the further at least one electrically insulating layer (115),
wherein the further electrically conductive structure (125) is configured as a further Rogowski coil, and
wherein the at least one electrically insulating layer (110) and the further at least one electrically insulating layer (115) are stacked, in particular oriented in parallel with each other.

10. The measurement device (100) according to claim 9, further comprising at least one of the following features:
wherein the further at least one electrically insulating layer (115) comprises a further opening (135);
wherein the opening (130) and the further opening (135) are aligned so that they can accommodate the object under measurement (250) in a common measurement position;
wherein the opening (130) and the further opening (135) have a similar or different diameter;
wherein the electrically conductive structure (120) and the further electrically conductive structure (125) have a similar or different number of windings;
wherein the electrically conductive structure (120) and the further electrically conductive structure (125) are electrically connected, in particular by at least one electric connector (160);
wherein the at least one electrically insulating layer (110) and the further at least one electrically insulating layer (115) are spatially separated, in particular by an air gap;
a further insertion structure in the further at least one electrically insulating layer (115), wherein the insertion structure (140) and the further insertion structure are at least partially aligned and/or wherein the insertion structure (140) and the further insertion structure are bendable at the same time.

11. The measurement device (100) according to one of the preceding claims, further comprising:
an evaluation device (180), in particular comprising at least one processor, to evaluate a measurement performed with respect to the Rogowski coil (120),
in particular so that the measurement device (100) is configured as a stand-alone device/module; and/or
a holding structure (150), in particular arranged at least partially around the opening (130), configured to hold the object under measurement (250) in place, in particular in the measurement position, more in particular in a centered measurement position.

12. A measurement device arrangement (200), comprising:
a measurement device (100) according to one of the preceding claims; and
the object under measurement (250) arranged in the measurement position with respect to the Rogowski coil (120),
in particular wherein the object under measurement (250) comprises a conductor, more in particular at least one of a cable, a wire, a trace, a busbar.

13. A method to handle a measurement device (100), the method comprising:
providing a measurement device (100) according to one of the preceding claims;
providing an object under measurement (250); and
arranging the object under measurement (250) at least partially in the measurement device (100) in the measurement position with respect to the Rogowski coil (120).

14. The method according to claim 13, further comprising:
at least partially bending the measurement device (100), in particular with respect to the insertion structure (140).

15. Using a Rogowski coil (120) in a flexible printed circuit board (100).
